# DEMANDE DE BREVET EUROPEEN

(11) **EP 4 535 093 A1**
(43) Date de publication de la demande: **09.04.2025**
(21) Numéro de dépôt: 23202215.2
(22) Date de dépôt: 06.10.2023
(51) Int. Cl.: G04B 37/00, G04B 37/11, G04G 17/00, G04G 17/08

(54) **ARTICLE ÉLECTRONIQUE PORTABLE COMPORTANT UN ORGANE DE SÉCURITÉ POUR SÉCURISER UN COUVERCLE D'UNE SOURCE D'ÉNERGIE ÉLECTRIQUE AMOVIBLE**

(71) Demandeur: ETA SA Manufacture Horlogère Suisse, 2540 Grenchen (CH)
(72) Inventeur: JOYE, David, 2537 Vauffelin (CH)
(74) Mandataire: ICB SA

(57) **Abrégé**

Un aspect de l'invention concerne un article électronique portable (100) comportant : un boîtier (10) présentant un compartiment (11) configuré pour recevoir et loger au moins une source d'énergie électrique amovible (2) ; un couvercle (20) de compartiment comportant des premiers moyens de couplage (23a) configurés pour coopérer avec des deuxièmes moyens de couplage (23b) ménagés au niveau du boîtier (10) de manière à solidariser le couvercle (20) au boîtier (10) par un mouvement de rotation dudit couvercle autour d'un axe de rotation formé par un axe central (X) du couvercle (20) ; ledit couvercle (20) présentant une empreinte (22) ménagée au niveau d'une face externe (21), ladite empreinte étant configurée pour recevoir un outil pour assurer la mise en rotation du couvercle (20) ; ledit article électronique portable (100) étant caractérisé en ce qu'il comporte un organe de sécurité (30, 30') solidarisé par collage sur ledit article électronique portable, ledit organe de sécurité (30, 30') étant configuré pour recouvrir au moins partiellement l'empreinte (22) du couvercle (20) de compartiment (11), de manière à empêcher l'introduction d'un outil pour la mise en rotation du couvercle (20) et son démontage du boîtier (10).

## Description

### Domaine technique de l'invention

L'invention concerne les articles électroniques portables alimentés par une source d'énergie électrique amovible, telle qu'une batterie, un accumulateur ou une pile, logée dans un compartiment d'un boîtier et fermé par un couvercle.

L'invention concerne plus particulièrement un organe de sécurité configuré pour sécuriser un couvercle d'une source d'énergie électrique amovible et pour empêcher son démontage, de manière à empêcher l'accessibilité à la source d'énergie électrique tant que l'organe de sécurité est en place.

L'invention trouve une application particulièrement intéressante dans le domaine de l'horlogerie et concerne plus particulièrement une montre électronique ou électromécanique.

### Arrière-plan technologique

Les articles électroniques portables peuvent être alimentés par une ou plusieurs sources d'énergie amovibles, telles que des batteries, des accumulateurs ou des piles.

Par exemple, les montres électroniques, ou électromécaniques, sont alimentées, au moins en partie pour les montres électromécaniques, par une source d'énergie électrique amovible, par exemple une pile bouton, qui est logée dans un compartiment de la boîte de montre. Un couvercle amovible est prévu pour enfermer la pile à l'intérieur du compartiment en garantissant au moins une étanchéité à l'eau du compartiment.

Pour assurer un remplacement aisé de la pile, le couvercle et la boîte présentent généralement des moyens de couplage/découplage rapides en rotation qui permettent un accès rapide à la pile, ainsi qu'une fermeture rapide du compartiment après remplacement de la pile. Ces moyens de couplage/découplage rapides sont par exemple des systèmes d'assemblage de type quart de tour ou encore des systèmes d'assemblage de type à baïonnette.

De plus, le couvercle peut présenter une empreinte au niveau de sa surface externe configurée pour recevoir l'extrémité d'un outil de manière à assurer sa mise en rotation. Pour faciliter davantage le remplacement de la pile, il est courant que cette empreinte présente une forme relativement simple et commune, par exemple une forme de fente, de manière à pouvoir utiliser divers accessoires à la portée du porteur pour l'ouverture du compartiment sans avoir besoin d'un outil spécifique, ou d'apporter la montre chez un horloger pour un remplacement de pile.

Toutefois, ces diverses solutions techniques intéressantes et avantageuses pour le remplacement de la pile peuvent par ailleurs présenter des inconvénients dans certaines situations, notamment lorsqu'elles sont manipulées par des enfants, et plus particulièrement des jeunes enfants. En effet, par inadvertance, ces jeunes enfants pourraient arriver à démonter le couvercle de pile et accéder au compartiment de la pile occasionnant un risque d'ingestion de celle-ci, avec les graves conséquences que cela peut impliquer.

Par conséquent, il existe un besoin de sécuriser ce type d'article portable pour éviter l'accessibilité au compartiment de la pile par une personne non responsable, et particulièrement les jeunes enfants, tout en gardant les avantages d'un démontage aisé et rapide du couvercle sans avoir besoin d'un outil spécifique.

### Résumé de l'invention

À cette fin, l'invention vise à proposer un organe de sécurité pour sécuriser un couvercle de compartiment d'une source d'énergie électrique amovible, telle qu'une pile, un accumulateur ou une batterie, d'un article électronique portable permettant de résoudre au moins un des inconvénients précités.

Dans ce contexte, l'invention concerne un article électronique portable comportant :
- un boîtier présentant un compartiment configuré pour recevoir et loger au moins une source d'énergie électrique amovible ;
- un couvercle de compartiment comportant des premiers moyens de couplage configurés pour coopérer avec des deuxièmes moyens de couplage ménagés au niveau du boîtier de manière à solidariser le couvercle au boîtier par un mouvement de rotation dudit couvercle autour d'un axe de rotation formé par un axe central du couvercle ; ledit couvercle présentant une empreinte ménagée au niveau d'une face externe, ladite empreinte étant configurée pour recevoir un outil pour assurer la mise en rotation du couvercle.

En outre, l'article électronique portable comporte un organe de sécurité solidarisé par collage sur ledit article électronique portable, ledit organe de sécurité étant configuré pour recouvrir au moins partiellement l'empreinte du couvercle de compartiment, de manière à empêcher l'introduction d'un outil pour la mise en rotation du couvercle et son démontage du boîtier.

Ainsi, l'organe de sécurité solidarisé par collage permet de rendre inutilisable l'empreinte tant que l'organe de sécurité est en place, en se superposant à l'empreinte de manière à la combler et/ou à la dissimuler.

Outre les caractéristiques évoquées dans le paragraphe précédent, l'article électronique portable selon l'invention peut présenter une ou plusieurs caractéristiques complémentaires parmi les suivantes, considérées individuellement ou selon toutes les combinaisons techniquement possibles :
- l'organe de sécurité comporte un corps principal présentant une surface plane, et des pattes anti-rotation, les pattes anti-rotation étant logées dans des encoches ménagées dans le boîtier, de sorte à empêcher la mise en rotation du couvercle par rapport au boîtier ;
- les pattes anti-rotation s'étendent dans un plan parallèle au plan de la surface plane du corps principal, selon une direction radiale par rapport à l'axe central X ;
- les pattes anti-rotation sont en saillies par rapport à la surface plane du corps principal, et s'étendent en direction du compartiment ;
- l'organe de sécurité est configuré pour recouvrir totalement l'empreinte du couvercle ;
- l'organe de sécurité est solidarisé par collage sur le couvercle ;
- le couvercle comporte une face externe et l'organe de sécurité est solidarisé par collage sur la face externe du couvercle ;
- l'article comporte un élément adhésif ménagé au niveau d'une face interne du corps principal assurant la solidarisation de l'organe de sécurité sur la face externe du couvercle ;
- l'organe de sécurité est solidarisé par collage au moins dans l'empreinte du couvercle ;
- l'article comporte un élément adhésif ménagé au niveau d'une face interne du corps principal assurant la solidarisation de l'organe de sécurité au moins dans l'empreinte du couvercle ;
- l'organe de sécurité est solidarisé par collage sur le boîtier ;
- chacune des pattes anti-rotation est solidarisée par collage dans le fond d'une encoche du boîtier via un élément adhésif ;
- l'élément adhésif est un film adhésif ou une colle ;
- le corps principal présente un dégagement autorisant le passage d'un outil de petites dimensions dans l'empreinte pour faciliter le décollement de l'organe de sécurité de l'article électronique portable ;
- l'organe de sécurité est en matière métallique ou en matière polymère ;
- l'article électronique portable est une pièce d'horlogerie.

### Brève description des figures

Les buts, avantages et caractéristiques de la présente invention apparaîtront à la lecture de la description détaillée ci-dessous faisant référence aux figures suivantes :
- la figure 1 est une vue illustrant le fond ou le dos d'un article électronique portable selon l'invention comportant un premier exemple de réalisation d'un organe de sécurité pour sécuriser un couvercle d'une source d'énergie électrique amovible, telle qu'une pile, un accumulateur ou une batterie ;
- la figure 2 est une vue semi-éclatée en perspective de l'article électronique portable illustré à la figure 1 ;
- la figure 3 illustre la mise en place de l'organe de sécurité sur l'article électronique portable illustré à la figure 1, lorsque le compartiment est fermé par le couvercle ;
- la figure 4 est une vue illustrant le fond ou le dos d'un article électronique portable selon l'invention comportant un deuxième exemple de réalisation d'un organe de sécurité pour sécuriser un couvercle;
- la figure 5 illustre plus précisément le deuxième exemple de réalisation de l'organe de sécurité illustré à la figure 4 ; la figure 5 représente plus précisément une vue de dessous illustrant la face destinée à être en regard avec le couvercle ;
- la figure 6 illustre un autre exemple de réalisation d'un couvercle présentant une autre forme d'empreinte ;
- la figure 7 illustre un troisième exemple de réalisation d'un organe de sécurité selon l'invention configuré pour s'intégrer dans l'empreinte du couvercle illustré à la figure 6 ;
- la figure 8 illustre un quatrième exemple de réalisation d'un organe de sécurité selon l'invention configuré pour s'intégrer dans l'empreinte du couvercle illustré à la figure 6.

Dans toutes les figures, les éléments communs portent les mêmes numéros de référence sauf précision contraire.

### Description détaillée de l'invention

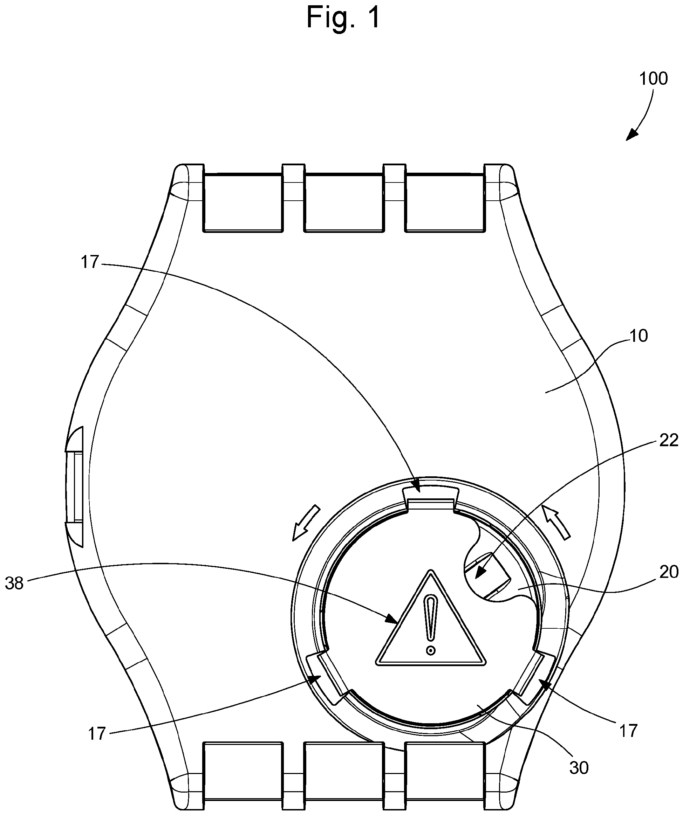

La figure 1 est une vue illustrant le fond ou le dos d'un boîtier d'un article électronique portable 100 selon l'invention comportant un premier exemple de réalisation d'un organe de sécurité d'un couvercle d'une source d'énergie électrique amovible, de type pile, accumulateur ou batterie.

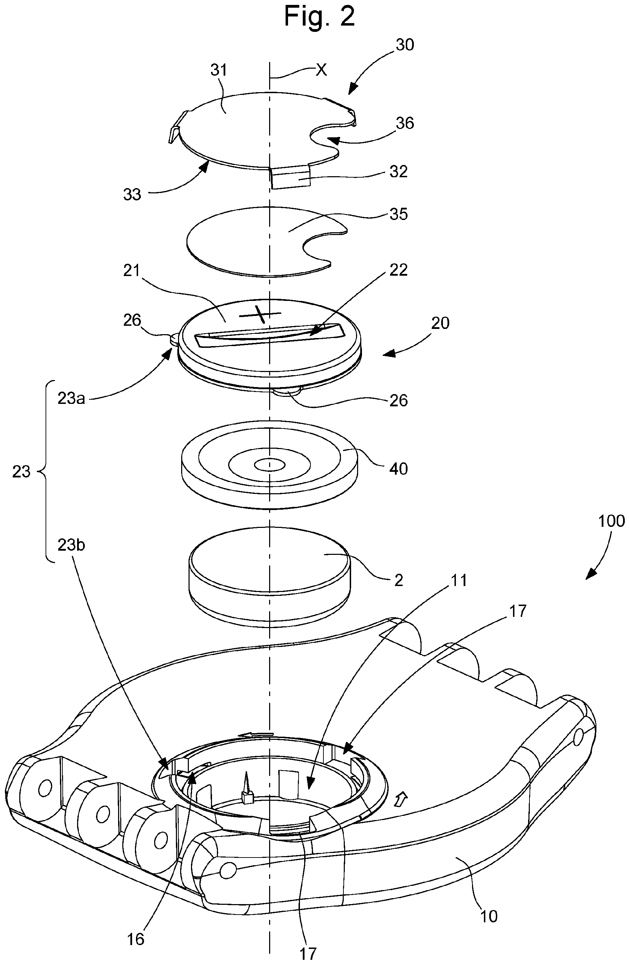

La figure 2 est une vue semi-éclatée en perspective de l'article électronique portable 100 illustré à la figure 1.

L'article électronique portable 100 est par exemple une pièce d'horlogerie, telle qu'une montre. Toutefois, d'autres exemples de réalisation sont possibles.

L'article électronique portable 100 comporte un boîtier 10 (ou boîte de montre lorsque l'article est une montre) renfermant une unité électronique (non représentée) alimentée par au moins une source d'énergie amovible, par exemple sous la forme d'une pile, d'un accumulateur ou d'une batterie.

Comme visible à la figure 2, le boîtier 10 présente un compartiment 11 configuré pour recevoir et loger au moins une source d'énergie électrique amovible 2.

Généralement, sur une montre, le compartiment 11 est situé à l'arrière de la montre, c'est-à-dire au niveau d'une partie de la montre destinée à venir en contact avec la peau de l'utilisateur.

Selon l'énergie électrique requise par l'article électronique portable, le compartiment 11 peut être dimensionné pour recevoir et loger plusieurs sources d'énergie électriques amovibles, par exemple plusieurs piles, accumulateurs ou batteries.

Dans la suite de la demande, on considérera que la source d'énergie électrique amovible 2 est une pile.

La pile 2 logée dans le compartiment 11 est par exemple une pile bouton.

Le compartiment 11 du boîtier 10 forme un logement, par exemple de forme cylindrique, s'étendant sensiblement selon un axe central X.

Le compartiment 11 du boîtier 10 est fermé par un couvercle 20 d'axe central X. La fermeture du compartiment 11 est réalisée par rotation du couvercle 20 selon l'axe central X.

Le couvercle 20 comporte des premiers moyens de couplage 23a configurés pour coopérer avec des deuxièmes moyens de couplage 23b ménagés au niveau du boîtier 10. Les moyens de couplage 23a, 23b sont configurés pour solidariser le couvercle 20 au boîtier 10 par un mouvement de rotation dudit couvercle selon l'axe central X. Les premiers moyens de couplage 23a et les deuxièmes moyens de couplage 23b forment ainsi un système de fixation 23 du couvercle 20 au boîtier 10.

Préférentiellement, les moyens de couplage 23a, 23b du système de fixation 23 sont des moyens de couplage rapide par rotation permettant une ouverture rapide et aisée du compartiment 11.

Préférentiellement, les moyens de couplage 23a, 23b sont par exemple des moyens permettant un couplage quart de tour ou un couplage à baïonnette.

Par exemple, le couvercle 20 comporte des languettes 26 s'étendant radialement par rapport à l'axe central X. Les languettes 26 sont configurées pour coopérer et s'insérer dans des rainures 16 ménagées dans le boîtier 10 en périphérie du compartiment 11. Ainsi, les languettes 26 du couvercle 20 forment les premiers moyens de couplage 23a et les rainures 16 du boîtier 10 forment les deuxièmes moyens de couplage 23b.

Selon une variante de réalisation, les moyens de couplage 23a, 23b sont des moyens de couplage par vissage, de sorte que le couvercle 20 est solidarisé par vissage sur le boîtier 10.

Le couvercle 20 présente une empreinte 22 ménagée au niveau d'une face externe 21, c'est-à-dire la face du couvercle 20 visible par l'utilisateur lorsque le couvercle 20 est couplé au boîtier 10.

L'empreinte 22 est formée par une surface en retrait par rapport à la face externe 21. L'empreinte 22 présente une forme adaptée pour recevoir l'extrémité d'un outil et assurer une mise en rotation du couvercle 20 lorsqu'on exerce un couple de rotation sur le couvercle 20 via l'outil.

Préférentiellement, l'empreinte 22 présente une forme simple. Par exemple, l'empreinte 22 présente une forme de rainure, d'encoche rectiligne ou de fente.

L'empreinte 22 peut également présenter d'autres formes plus complexes.

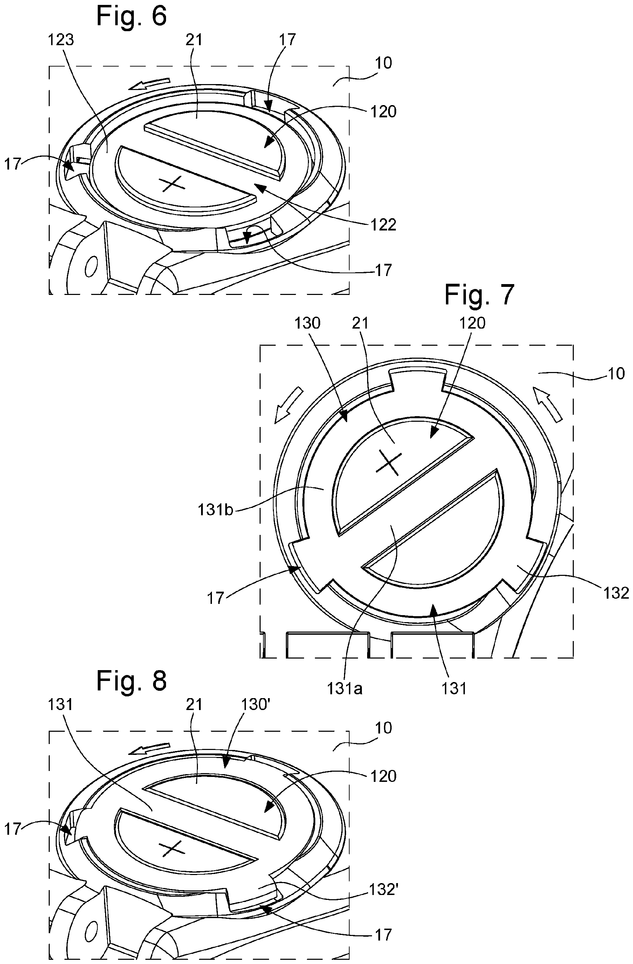

La figure 6 illustre un autre exemple de réalisation d'une empreinte 122 en forme de rainure rectiligne. Dans cet exemple de réalisation, l'empreinte 122 communique avec une rainure circonférentielle 123 faisant le pourtour de la face externe 21 du couvercle 120.

Le boîtier 10 comporte en outre des encoches 17 s'étendant sensiblement selon l'axe X et dans lesquelles les rainures 16 débouchent. Le boîtier 10 comporte autant d'encoches 17 que le couvercle 20 comporte de languettes 26.

Les encoches 17 sont configurées pour recevoir des languettes 26 du couvercle 20 en vue d'un couplage du couvercle 20 par rotation de celui-ci engageant les languettes 26 dans les rainures 16. Lorsque les languettes 26 sont en fond de rainures 16, le couvercle 20 est couplé au boîtier 10 et le compartiment 11 est fermé.

Les rainures 16 peuvent présenter un relief ou un bossage pour indiquer le passage d'une certaine position angulaire et indiquer de manière sensorielle une fermeture correcte du couvercle 20.

Comme représenté à la figure 2, une membrane élastique 40 est intercalée entre la pile 2 et le couvercle 20 de manière à assurer une étanchéité du compartiment 11.

L'article électronique portable 100 comporte en outre un organe de sécurité 30 collé sur l'article électronique portable 100.

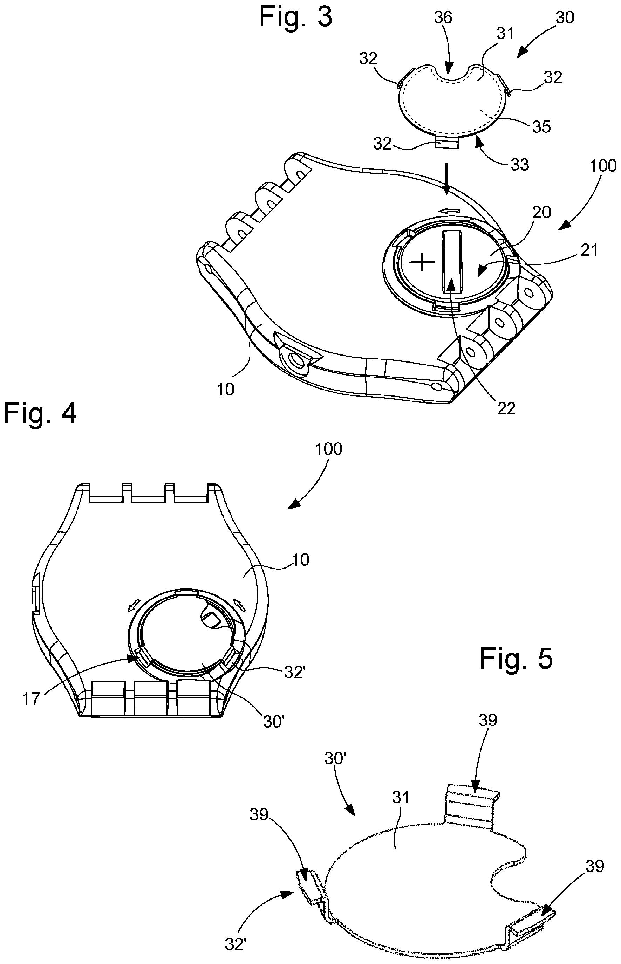

L'organe de sécurité 30 est une pièce rapportée solidarisée par collage sur l'article électronique portable 100 une fois que le couvercle 20 est couplé au boîtier 10 et ferme le compartiment 11, comme illustré à la figure 3. En référence à la figure 3, le couvercle 20 est en position fermé sur le boîtier 10 et les languettes 26 du couvercle 20 sont dans les rainures 16.

L'organe de sécurité 30 comporte un corps principal 31 formant une surface plane et des pattes anti-rotation 32.

Dans l'exemple de réalisation représenté aux figures 1 à 3, les pattes anti-rotation 32 sont en saillies par rapport à la surface plane du corps principal 31.

Le corps principal 31 est suffisamment rigide pour ne pas se déformer sous son propre poids lorsqu'il est maintenu par une extrémité. Ainsi, l'organe de sécurité 30 est une pièce « rigide » qui se différencie d'une étiquette souple.

Les pattes anti-rotation 32 sont des pattes qui s'étendent en relief par rapport à surface plane du corps principal 31. Elles forment ainsi un angle compris environ entre 45° et 120° par rapport au plan formé par la surface plane du corps principal 31, et sont dirigées en direction du boîtier 10.

Les pattes anti-rotation 32 sont configurées pour venir s'insérer et coopérer avec des encoches du boîtier 10 de manière à bloquer toute rotation de l'organe de sécurité 30 autour de l'axe X. Ainsi, lorsque l'organe de sécurité 30 est solidarisé par collage sur l'article électronique portable 100 en recouvrant le couvercle 20, la mise en rotation du couvercle 20 et son démontage n'est plus possible.

Préférentiellement, on utilise les encoches 17 servant au montage du couvercle 20 et qui sont libres, lorsque le couvercle 20 est en position fermée, pour loger les pattes anti-rotation de l'organe de sécurité 30.

Toutefois, selon les besoins il est également possible de réaliser des encoches spécifiques dans le boîtier 10 pour recevoir les pattes anti-rotation 32 de l'organe de sécurité 30.

Le corps principal 31 de l'organe de sécurité 30 est configuré pour recouvrir au moins partiellement le couvercle 20 et son empreinte 22, c'est-à-dire la surface en retrait formant l'empreinte 22, et préférentiellement une grande partie du couvercle 20 et de l'empreinte 22.

Ainsi, l'organe de sécurité 30 permet de rendre inutilisable l'empreinte 22 tant que l'organe de sécurité 30 est en place, en se superposant à l'empreinte 22.

Le corps principal 31 est dimensionné pour recouvrir suffisamment l'empreinte 22 du couvercle 20 de sorte qu'il n'est plus possible d'engager un outil dans l'empreinte 22 et donc d'engager en rotation le couvercle 20 en utilisant l'outil dans l'empreinte 22.

Le corps principal 31 présente par exemple une forme de disque ou de pastille dont le diamètre est sensiblement équivalent au diamètre du couvercle 20.

Le corps principal 31 peut présenter un dégagement 36, une rupture de forme, une ouverture, ou une lumière configurée pour permettre à un outil de petites dimensions d'atteindre l'empreinte 22 du couvercle 20 sur une portion limitée. Ainsi, il est possible d'utiliser un outil de plus petites dimensions que celui nécessaire pour la mise en rotation du couvercle 20 via l'empreinte 22, pour faciliter le démontage et la désolidarisation l'organe de sécurité 30 du couvercle 20, notamment lorsqu'il est nécessaire d'ouvrir le compartiment 11 pour changer la pile 2. Toutefois, ce dégagement 36 n'est pas suffisant pour pouvoir entrainer le couvercle en rotation en utilisant l'empreinte 22 et un outil adapté à l'empreinte 22.

L'organe de sécurité 30 est solidarisé par collage sur l'article électronique portable 100, par exemple au moyen d'un élément adhésif 35.

Dans ce premier exemple de réalisation illustré aux figures 1 à 3, l'organe de sécurité 20 est solidarisé par collage au couvercle 20 via un élément adhésif 35.

Dans ce premier exemple de réalisation, l'élément adhésif 35 est ménagé sur la face interne 33 du corps principal 31 de l'organe de sécurité 30 pour solidariser par collage l'organe de sécurité 30 sur la face externe 21 du couvercle 20.

Ainsi, l'élément adhésif 35 forme une interface de collage entre la face interne 33 du corps principal 31 et la face externe 21 du couvercle 20.

Bien entendu, de manière générale dans la présente demande la face externe est la face dirigée vers l'extérieur de l'article électronique portable et de manière opposée, la face interne est la face dirigée vers l'intérieur de l'article électronique portable.

L'élément adhésif 35 est par exemple un film adhésif, par exemple de type double face, une colle, ou un autre élément équivalent.

Lorsque l'élément adhésif 35 est un film adhésif, le film adhésif peut présenter une forme sensiblement équivalente à la forme du corps principal 31, avec si besoin une forme permettant de suivre le dégagement 36 du corps principal 31.

Le film adhésif ou plus généralement l'élément adhésif 35 peut également être de plus petites dimensions que les dimensions du corps principal 31 de l'organe de sécurité 30.

Préférentiellement, l'élément adhésif 35 est résistant à une température au moins égale à 90°C.

Comme visible à la figure 1, lorsque l'organe de sécurité 30 est collé sur le couvercle 20, les pattes anti-rotation 32 sont logées dans les encoches 17 de sortent qu'elles empêchent la rotation du couvercle 20.

Pour désolidariser l'organe de sécurité 30 lors d'un changement de pile, l'utilisateur peut aisément utiliser un outil de faibles dimensions pour l'insérer sous le corps principal 31 au niveau du dégagement 36 du corps principal 31 en utilisant avantageusement le retrait de matière au niveau de l'empreinte 22 du couvercle 20. Une fois l'organe de sécurité 30 désolidarisé, l'utilisateur a accès à l'empreinte 22 du couvercle 20 lui permettant d'engager en rotation celui-ci et d'accéder à la pile 2 logée dans le compartiment 11.

Dans un deuxième exemple de réalisation illustré aux figures 4 à 5, l'organe de sécurité 30' est solidarisé par collage au boîtier 10 par l'intermédiaire des pattes anti-rotation 32'.

À cet effet, comme représenté à la figure 5, les pattes anti-rotation 32' présentent une forme en S délimitant une surface d'appui 39 configurée pour venir reposer dans le fond d'une encoche 17. La surface d'appui 39 est suffisamment large et plane pour coopérer avec le fond des encoches 17 et pour recevoir un élément adhésif 35 d'interface pour solidariser par collage l'organe de sécurité 30' dans les encoches 17 du boîtier 10.

Préférentiellement, la surface d'appui 39 des pattes anti-rotation 32' est sensiblement parallèle à la surface plane du corps principal 31.

La figure 7 illustre un troisième exemple de réalisation d'un organe de sécurité 130 pour couvercle de pile ou de batterie 120.

Ce troisième exemple de réalisation est configuré pour coopérer avec la forme du couvercle 120 illustré à la figure 6 dont la face externe 21 comporte une empreinte 122 en forme de rainure rectiligne communiquant avec une rainure circonférentielle 123 faisant le pourtour de la face externe 21 du couvercle 120.

Dans ce troisième exemple de réalisation, l'organe de sécurité 130 comporte un corps 131 présentant une surface plane configurée pour s'intégrer dans l'empreinte 122, de manière à combler au moins partiellement l'empreinte 122 et à recouvrir l'empreinte 122, ou plus précisément à recouvrir la surface en retrait formant l'empreinte 122.

Ainsi, dans ce troisième exemple de réalisation, le corps 131 présente une portion centrale 131a et une portion périphérique 131b configurées pour s'intégrer respectivement dans l'empreinte 122 et dans la rainure circonférentielle 123 du couvercle 120. Le corps 131 présente ainsi une forme de cercle barré représentant le symbole d'une interdiction qui vient recouvrir l'empreinte 122.

Préférentiellement, l'épaisseur du corps 131 est sensiblement égale à la profondeur de l'empreinte 122.

L'organe de sécurité 130 est collé via un élément adhésif 35 ménagé au niveau de la face interne du corps 131.

L'organe de sécurité 130 est collé au moins dans l'empreinte 122, préférentiellement dans l'empreinte 122 et dans la rainure circonférentielle 123 du couvercle 120.

Dans ce troisième exemple de réalisation, l'organe de sécurité 130 comporte des pattes anti-rotation 132 s'étendant radialement par rapport à l'axe central X et qui s'étendent dans le même plan ou dans un plan parallèle au plan de la surface plane du corps 131.

De manière identique aux exemples de réalisation décrits précédemment, les pattes anti-rotation 132 sont configurées pour être logées dans les encoches 17 du boîtier 10. Ainsi, une mise en rotation du couvercle 120 n'est plus possible tant que l'organe de sécurité 130 est solidarisé par collage sur le couvercle.

La figure 8 illustre un quatrième exemple de réalisation qui est une variante de réalisation du troisième exemple de réalisation décrit précédemment en référence à la figure 7. Dans ce quatrième exemple de réalisation, l'organe de sécurité 130' comporte des pattes anti-rotation 132' en saillies par rapport à la surface plane du corps principal 131' et qui s'étendent en direction du compartiment 11 pour être logées plus en profondeur dans les encoches 17 du boîtier 10. Ainsi, une mise en rotation du couvercle 120 n'est plus possible tant que l'organe de sécurité 130' est en place sur le couvercle.

Dans un cinquième exemple de réalisation simplifié, l'organe de sécurité ne comporte pas de pattes anti-rotation. Dans ce cinquième exemple de réalisation, le corps principal 31, 131 est solidarisé par collage sur le couvercle de manière à recouvrir l'empreinte 22, 122 comme décrit précédemment en référence aux figures 1 à 3 et 6 à 8.

Dans ce cinquième exemple de réalisation, le corps principal 31 peut présenter une forme de disque ou de pastille, dont le diamètre est sensiblement équivalent au diamètre du couvercle.

Dans ce cinquième exemple de réalisation, le corps principal 31 peut également présenter une forme telle que décrite en référence aux figures 7 et 8.

Quel que soit l'exemple de réalisation, l'organe de sécurité 30, 30', 130, 130' est réalisé en matière métallique ou en matière polymère.

Comme représenté la figure 1, l'organe de sécurité 30, 30' peut également comporter un pictogramme 38 de sécurité, de danger ou de prévention visible sur la face externe de l'organe de sécurité 30, 30'.

## Revendications

1. Article électronique portable (100) comportant :
- un boîtier (10) présentant un compartiment (11) configuré pour recevoir et loger au moins une source d'énergie électrique amovible (2) ;
- un couvercle (20, 120) de compartiment comportant des premiers moyens de couplage (23a) configurés pour coopérer avec des deuxièmes moyens de couplage (23b) ménagés au niveau du boîtier (10) de manière à solidariser le couvercle (20, 120) au boîtier (10) par un mouvement de rotation dudit couvercle autour d'un axe de rotation formé par un axe central (X) du couvercle (20, 120) ; ledit couvercle (20, 120) présentant une empreinte (22, 122) ménagée au niveau d'une face externe (21), ladite empreinte étant configurée pour recevoir un outil pour assurer la mise en rotation du couvercle (20, 120) ;
ledit article électronique portable (100) étant **caractérisé en ce qu'**il comporte un organe de sécurité (30, 30', 130, 130') solidarisé par collage sur ledit article électronique portable, ledit organe de sécurité (30, 30', 130, 130') étant configuré pour recouvrir au moins partiellement l'empreinte (22, 122) du couvercle (20, 120) de compartiment (11), de manière à empêcher l'introduction d'un outil pour la mise en rotation du couvercle (20, 120) et son démontage du boîtier (10).

2. Article électronique portable (100) selon la revendication précédente **caractérisé en ce que** l'organe de sécurité (30, 30', 130, 130') comporte :
- un corps principal (31, 131) présentant une surface plane, et
- des pattes anti-rotation (32, 32', 132, 132'),
les pattes anti-rotation (32, 32', 132, 132') étant logées dans des encoches (17) ménagées dans le boîtier (10), de sorte à empêcher la mise en rotation du couvercle (20) par rapport au boîtier (10).

3. Article électronique portable (100) selon la revendication 2 **caractérisé en ce que** les pattes anti-rotation (132) s'étendent dans un plan parallèle au plan de la surface plane du corps principal (131), selon une direction radiale par rapport à l'axe central (X).

4. Article électronique portable (100) selon la revendication 2 **caractérisé en ce que** les pattes anti-rotation (32, 32', 132') sont en saillies par rapport à la surface plane du corps principal (31, 131), et s'étendent en direction du compartiment (11).

5. Article électronique portable (100) selon l'une des revendications 1 à 4 **caractérisé en ce que** l'organe de sécurité (130, 130') est configuré pour recouvrir totalement l'empreinte (122) du couvercle (120).

6. Article électronique portable (100) selon l'une des revendications 1 à 5 **caractérisé en ce que** l'organe de sécurité (30, 30' 130, 130') est solidarisé par collage sur le couvercle (20, 120).

7. Article électronique portable (100) selon la revendication 6 **caractérisé en ce que** le couvercle (20) comporte une face externe (21) et **en ce que** l'organe de sécurité (30) est solidarisé par collage sur la face externe (21) du couvercle (20).

8. Article électronique portable (100) selon la revendication 7 **caractérisé en ce qu'**il comporte un élément adhésif (35) ménagé au niveau d'une face interne (33) du corps principal (31) assurant la solidarisation de l'organe de sécurité (30) sur la face externe (21) du couvercle (20).

9. Article électronique portable (100) selon la revendication 6 **caractérisé en ce que** l'organe de sécurité (130, 130') est solidarisé par collage au moins dans l'empreinte (122) du couvercle (120).

10. Article électronique portable (100) selon la revendication 9 **caractérisé en ce qu'**il comporte un élément adhésif (35) ménagé au niveau d'une face interne (33) du corps principal (131) assurant la solidarisation de l'organe de sécurité (130, 130') au moins dans l'empreinte (122) du couvercle (120).

11. Article électronique portable (100) selon l'une des revendications 2 à 5 **caractérisé en ce que** l'organe de sécurité (30') est solidarisé par collage sur le boîtier (10).

12. Article électronique portable (100) selon la revendication 11 **caractérisé en ce que** chacune des pattes anti-rotation (32') est solidarisée par collage dans le fond d'une encoche (17) du boîtier (10) via un élément adhésif (35).

13. Article électronique portable (100) selon la revendication 8 ou 10 ou 12 **caractérisé en ce que** l'élément adhésif (35) est un film adhésif ou une colle.

14. Article électronique portable (100) selon l'une des revendications précédentes **caractérisé en ce que** le corps principal (31) présente un dégagement (36) autorisant le passage d'un outil de petites dimensions dans l'empreinte (22) pour faciliter le décollement de l'organe de sécurité (30, 30') de l'article électronique portable (100).

15. Article électronique portable (100) selon l'une des revendications précédentes **caractérisé en ce que** l'organe de sécurité (30, 30', 130, 130') est en matière métallique ou en matière polymère.

16. Article électronique portable (100) selon l'une des revendications précédentes **caractérisé en ce que** l'article électronique portable (100) est une pièce d'horlogerie.
